(19) Europäisches Patentamt
European Patent Office
Office européen des brevets

(11) **EP 3 015 827 B1**

(12) **EUROPEAN PATENT SPECIFICATION**

(45) Date of publication and mention
of the grant of the patent:
**28.03.2018 Bulletin 2018/13**

(51) Int Cl.:
*H03K 17/082* (2006.01)   *B60R 16/023* (2006.01)
*H03K 17/615* (2006.01)   *B60R 16/03* (2006.01)

(21) Application number: **14190944.0**

(22) Date of filing: **29.10.2014**

(54) **Sensor system**

Sensorsystem

Système de détection

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.05.2016 Bulletin 2016/18**

(73) Proprietor: **Delphi International Operations
Luxembourg S.à r.l.
4940 Bascharage (LU)**

(72) Inventor: **Wiethege, Eric
51469 Bergisch Gladbach (DE)**

(74) Representative: **Robert, Vincent et al
Delphi France SAS
Bâtiment Le Raspail - Paris Nord 2
22, avenue des Nations
CS 65059 Villepinte
95972 Roissy CDG Cedex (FR)**

(56) References cited:
FR-A1- 2 980 654       GB-A- 2 307 609
US-A1- 2002 093 418    US-A1- 2013 249 570

**Description**

TECHNICAL FIELD

This invention relates to a sensor system, and more particularly to a driver to control the sensor.

BACKGROUND OF THE INVENTION

For Keyless Passive Entry, vehicles are usually equipped with sensors in the door handles used to detect if the user wants to open or close the car. As per example, the sensors are capacitive proximity sensors. These capacitive proximity sensors usually contain a small Micro Controller which detects if there is capacitance change and therefore authorizes the user to open or close the car. For cost reason the sensors are usually connected with two wires: supply voltage and electrical ground. The data are sent to the connected control module via load modulation. For supplying the sensor, the control module contains a driver which is capable to supply the sensor and detect, if there is a load modulation. Usually this driver has to be switched on if the control module is in sleep mode. (e.g. vehicle is in sleep mode, capacitive sensor is active to detect if the user wanted to open the vehicle). In vehicle sleep mode, any current consumption has to be minimized not to discharge vehicles battery. Usually there is some current needed to switch on the driver. It may happen that the activation of the driver requires more current than the sensor itself in the armed state and especially the driver could use current without power consumption on the output.

Principle for the driver stage is the use of a standard Gate. There are Gates available on the market which works higher than 16V operating voltage, which is sufficient in automotive use. Usually these gates have push-pull output stages. Usually the driver strength of such a gate is too small to drive directly a load such a capacitive sensor. The current consumption of the gate itself is very low in normal temperature range. At extreme temperatures the leakage current increases. Such a gate has several outputs and it is possible to connect several of these driver structures. To enhance the current output capability a simple emitter follower could be added. Neglecting the gate leakage current, the driver could be switched on (without load) without additional current consumption. Depending on the gate supply voltage, the gate output current capability has a wide variation about temperature and supply voltage. If a short circuit occurs at the output, the transistor is working in a linear range and consuming power. To survive this until the microcontroller detects that and switch off, the transistor needs much thermal capacitance. This results in "big" transistors. These kinds of Transistors have usually a small current gain. Then it could not be guaranteed to switch on this transistor in normal conditions properly. Document US2013/249570 relates to a sensor and a method for detecting an object.

It is an object of the invention to provide an improved sensor system that overcomes such problems.

SUMMARY OF THE INVENTION

The present invention relates to a sensor system that enables the use of a very low power gate supply interfaced with a sensor that may effectively reduce the current consumption of a vehicle equipped with a passive keyless entry system when the vehicle is in a standby mode, i.e. when the vehicle is parked with the engine off.

The sensor system is not limited to passive keyless entry application, it can be used in a vehicle for any kind of functions where the detection of a part of the human body (hands, foot, fingers...) is needed.

The sensor system for the vehicle is configured to interface a gate supply with a sensor and comprises the sensor to detect a user and comprises the gate supply to provide power to an apparatus. The apparatus comprises an input connected to the gate supply for receiving power from the gate supply, a circuitry for boosting a level of the power received from the gate supply, and an output connected to the sensor for providing the boosted level of power to the sensor. The circuitry comprises a NPN bipolar transistor having a base, a collector and an emitter. The circuitry further comprises a PNP bipolar transistor having another base, another collector and another emitter. The NPN bipolar transistor is an input transistor. The PNP bipolar transistor is the output transistor. The base of the input transistor is connected to the input of the apparatus. The collector of the output transistor and the emitter of the input transistor are connected together to the output of the apparatus. The emitter of the output transistor is connected to a supply voltage and the collector of the input transistor is connected to the base of the output transistor.

The result is that a high current gain to operate the sensor is obtained with standard small bipolar transistors.

The sensor system may further comprise a switch for enabling/disabling the gate supply.

The gate supply may comprises an electrical source providing power to the input of the apparatus when enabled.

The gate supply may provide an electrical ground to the input of the apparatus when disabled.

The circuitry may further comprise a first series resistor connected between the base and the emitter of the input transistor, such that the output of the apparatus is connected to the electrical ground when the gate supply is disabled

The circuitry may further comprise a sensing element connected immediately in series with the collector of the output transistor, the sensing element detecting a load modulation on the output of the apparatus occurring when the sensor detects the user.

The sensor system may further comprise a supervisor for supervising the sensing element.

The sensing element may be a sense resistor connected immediately in series with the collector of the output transistor, the load modulation inducing a voltage variation over the sense resistor.

The circuitry may further comprise a second series resistor connected immediately in series with the emitter of the input transistor, the second series resistor being adapted to withstand with short circuit to ground on the output.

The circuitry may further comprise a third series resistor connected between the input of the apparatus and the gate supply.

Any one of the resistors of the sensor system may be the sensing element.

The gate supply may be a Complementary Metal Oxide Semiconductor (CMOS) gate.

The circuitry may further comprise a diode having an anode and a cathode, the anode being connected to the emitter of the input transistor, and the cathode being connected to the base of the input transistor.

The sensor may be a proximity sensor.

A vehicle may comprise the sensor system.

A door handle of the vehicle may comprise the sensor.

BRIEF DESCRIPTION OF THE DRAWINGS

This invention will be further described by way of non-limitative example and with reference to the accompanying drawings in which:

Figure 1 is a schematic diagram of a proximity sensor system.
Figure 2 is a schematic diagram of a proximity sensor system, in accordance with the invention.
Figure 3 is a schematic diagram of a proximity sensor system, in accordance with another example of the invention.
Figure 4 is a schematic diagram of a proximity sensor system, in accordance with another further example of the invention.

DESCRIPTION OF THE PREFERRED EMBODIMENTS

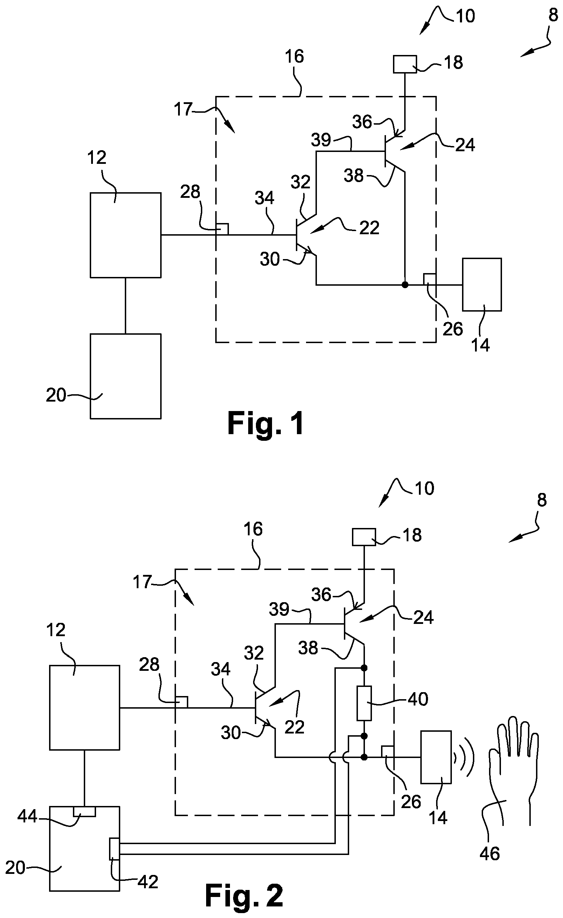

Figure 1 is a schematic diagram of a proximity sensor system 10 for a vehicle 8. The system 10 is comprises a gate supply 12, a proximity sensor 14, an apparatus 16, a supply voltage 18 and a microcontroller 20. The apparatus 16 is connected to the supply voltage 18. The apparatus 16 comprises an input 28. The gate supply 12 is connected to the input 28 of the apparatus 16. The gate supply 12 delivers power to the input 28 of the apparatus 16 from its electrical source (not represented). The apparatus 16 comprises an output 26. The proximity sensor 14 is connected to the output 26 of the apparatus 16. The apparatus 16 comprises a circuitry 17 boosting a level of the power received from the gate supply 12. The apparatus 16 delivers the boosted level of power to the proximity sensor 14. The circuitry 17 comprises a NPN bipolar transistor 22 having a base 34, a collector 32 and an emitter 30. The circuitry 17 further comprises a PNP bipolar transistor 24 having another base 39, another collector 38 and another emitter 36.

The NPN bipolar transistor 22 is an input transistor 22 and the PNP bipolar transistor 24 is an output transistor 24. The base 34 of the input transistor is connected to the input 28 of the apparatus 16. The collector 38 of the output transistor 24 and the emitter 30 of the input transistor 22 are connected together to the output 26 of the apparatus 16. The emitter 36 of the output transistor 24 is connected to the supply voltage 18, the collector 32 of the input transistor 22 is connected to the base 39 of the output transistor 24.

The microcontroller 20 is connected to the gate supply 12. The microcontroller 20 has the ability to enable or to disable the gate supply 12. When enabled by the microcontroller 20, the gate supply 12 may provide power to the input 28 of the apparatus 16. When disabled by the microcontroller 20, the gate supply 12 may provide an electrical ground to the input 28 of the apparatus 16. In that case, the apparatus 16 does not deliver any power to the proximity sensor 14.

The proximity sensor 14 can be replaced by any kind of sensor as tactile sensor or motion sensor. The sensor system 10 may be placed in the vehicle 8 wherein a human to machine interface, such as a door handle or a center console between front occupants, is equipped with the sensor 14.

Figure 2 illustrates a proximity sensor system 10 according to the invention. The drawing shows similar components and reference numerals as before. The embodiment further includes a sense resistor 40, an analog to digital converter 42 and a switch 44.

The sense resistor 40 is connected immediately in series with the collector 38 of the output transistor 24. 'Connected immediately in series' in the sense of the electronic domain stands for the fact that there is no other electronic component between two element connected in series. One pole of the sense resistor is connected to the collector 38 of the output transistor 24. The other pole of the sense resistor 40 is the connected to the output 26 of the apparatus 16.

The analog to digital converter 42 is located inside the microcontroller 20 and it is connected to the sense resistor 40. It is connected in such a manner that it can detect a voltage variation over the sense resistor 40. It is connected in a differential manner on the two poles of the sense resistor 40.

The analog to digital converter 42 detects the voltage variation over the sense resistor 40 induced by a load modulation generated by proximity sensor 14 excited by a hand 46 of a user.

Alternatively, the analog to digital converter 42 can detect a current variation. The analog to digital converter 42 can be also placed externally to the microcontroller 20 as long as it is connected to the microcontroller 20.

Alternatively, the means to detect a current or a voltage variation on the sense resistor can be a simple transistor, a Hall Effect device or other well-known solutions.

The switch 44 located inside the microcontroller 20 is connected to the gate supply 12. It is connected in such a manner that the switch 44 of the microcontroller 20 can enable or disable the gate supply 12. The switch 44 may be used in case a current consumption control on the proximity sensor system 10 is required. By disabling the gate supply 12, the current consumption of the proximity sensor system 10 is reduced.

A specific technology, such as a Complementary Metal Oxide Semiconductor (CMOS) technology may be chosen for the gate supply 12 in order to minimize the current consumption of the proximity sensor system 10 when it is enabled.

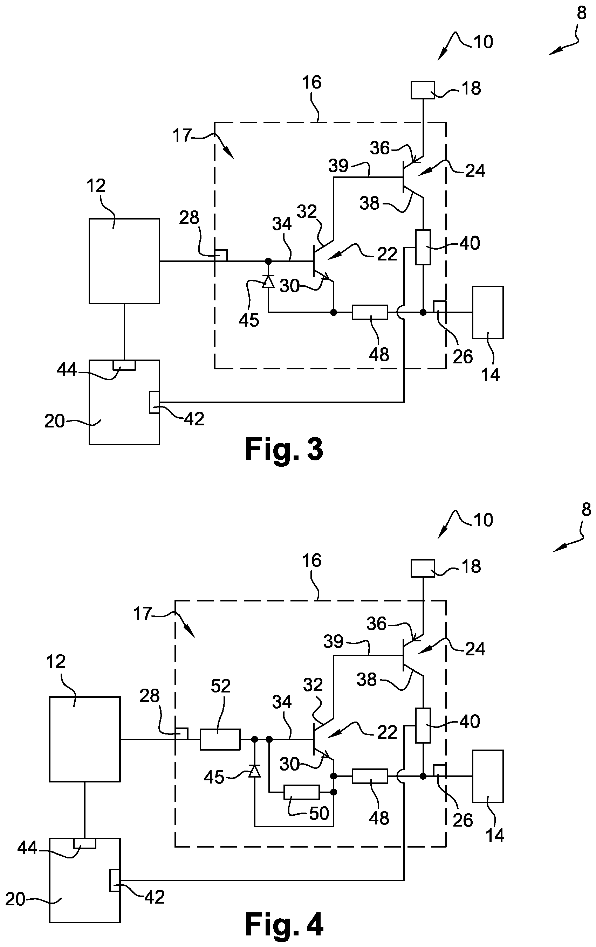

Figure 3 illustrates a further preferred embodiment of the proximity sensor system 10. The drawing shows similar components and reference numerals as before. The embodiment further includes an additional resistor 48 which is a series resistor 48 placed directly in series between the emitter 30 of the input transistor 22 and the output 26 of the apparatus 16. The series resistor 48 is a part of the input transistor 22 protection against a short circuit to ground on the output 26 of the apparatus 16.

In case of a short circuit to ground (GND), the emitter 30 of the input transistor 22 is tied via the series resistor 48 to low and the current of the collector 32 of the input transistor 22 is increased. The input NPN transistor 22 is fully conducting. The increased current of the collector 32 of the input transistor 22 forces the output transistor 24 to conduct stronger. The output PNP transistor 24 is also fully conducting. The result is that the most power is consumed at the sense resistor 40. Therefore small transistors could be used and the power consumption at the sense resistor 40 could be handled easily by choosing different sizes. The size of the sense resistor 40 depends on several factors which could be calculated easily. The person skilled in the art knows how to calculate a resistor by taking into account criteria as current, voltage and temperature.

As an option, in order to protect the circuitry against a short circuit to the supply voltage 18, the circuitry may further comprises a diode 45 having an anode and a cathode, the anode being connected to the emitter 30 of the input transistor 22, and the cathode being connected to the base 34 of the input transistor 22.

Figure 4 illustrates a further preferred embodiment of the proximity sensor system 10. The drawing shows similar components and reference numerals as before. The embodiment further includes two other resistors. One of the two resistors is a NPN base emitter resistor 50 connected directly between the base 34 of the input NPN transistor 22 and the emitter 30 of the input NPN transistor 22. The other resistor is a NPN base resistor 52 connected directly between the input 28 of the apparatus 16 and the base 34 of the input NPN transistor 22.

In such configuration, the apparatus works as following. The current consumption from the proximity sensor 14 pulls the emitter 30 of the input NPN transistor 22 down. This causes the input NPN transistor 22 to consume current from the base 39 of the output PNP transistor 24 which starts conducting and also supplying the proximity sensor 14. At the input NPN transistor 22, the current of base 34 and the current of the emitter 30 are flowing to the proximity sensor 14. At the output PNP transistor 24, the current of the collector 38 is flowing to the proximity sensor 14 and the current of the base 39 of the output PNP transistor 24 is equal to the current of the collector 32 of the input NPN transistor 22, which is part of the current of the emitter 30 of the input NPN transistor 22.

The result is that the whole current is flowing to the proximity sensor 14 itself and there is no additional current to ground for activating the proximity sensor. The formula providing the boosted current delivered by the apparatus 16 to the proximity sensor 14 when the input 28 of the apparatus 16 is supplied by the gate supply 12 is given by:

$$Iproximity\_sensor = Ipnp\_collector + Inpn\_emitter$$

While Inpn_emitter = Inpn_collector + Inpn_base
and while Ipnp collector = Ipnp_base
Finally: Iproximity_sensor = Ipnp _collector + Inpn base + Inpn _collector
Wherein:

Iproximity_sensor stands for the current delivered by the apparatus 16 to the proximity sensor 14.

Ipnp_collector stands for the current flowing through the collector 38 of the output PNP transistor 24.

Inpn_emitter stands for the current flowing through the emitter 30 of the input NPN transistor 22.

Inpn_collector stands for the current flowing through the collector 32 of the input NPN transistor 22.

Inpn_base stands for the current flowing through the base 34 of the input NPN transistor 22.

Ipnp_base stands for the current flowing through the base 39 of the output PNP transistor 24.

When disabled by the microcontroller 20, the gate supply 12 may provide an electrical ground to the input 28 of the apparatus 16. In that case, the apparatus 16 does not deliver any power to the proximity sensor 14. The gate supply 12 provides a ground level to the input 28 of the apparatus16.

The input NPN transistor 22 and the output PNP transistor 24 stop conducting current. The output 26 of the apparatus 16 is pulled to ground level via the sum of resistors: the series resistor 48, the NPN bases emitter resistor 50 and the NPN base resistor 52.

Alternatively, if the input 28 of the apparatus 16 is directly connected to the base 34 of the NPN input transistor 22, the output 26 of the apparatus 16 is also pulled to ground level via the sum of resistors: the series resistor 48 and the NPN bases emitter resistor 50.

Alternatively each individual resistor can play the role of the sense resistor 40, i.e. a detection of their voltage variation may be considered as an excitation of the proximity sensor 14.

## Claims

1. A sensor system (10) for vehicles configured to interface a gate supply (12) with a sensor (14), the system (10) comprising:

> the sensor (14) detecting a user (46);
> the gate supply (12) providing power to an apparatus (16);
> the apparatus (16) comprising:
>
> > an input (28) connected to the gate supply (12) for receiving power from the gate supply (12);
> > a circuitry (17) boosting a level of the power received from the gate supply (12); and
> > an output (26) connected to the sensor (14) for providing the boosted level of power to the sensor (14);
> > wherein the circuitry (17) comprises:
> >
> > > a switch (44) for enabling/disabling the gate supply (12);
> > > a NPN bipolar transistor (22) having a base (34), a collector (32) and an emitter (30);
> > > a PNP bipolar transistor (24) having another base (39), another collector (38) and another emitter (36);
> > > the NPN bipolar transistor (22) is an input transistor (22);
> > > the PNP bipolar transistor (24) is the output transistor (24);
> > > the base (34) of the input transistor (22) is connected to the input (28) of the apparatus (16);
> > > the collector (38) of the output transistor (24) and the emitter (30) of the input transistor (22) are connected together to the output (26) of the apparatus (16);
> > > the emitter (36) of the output transistor (24) is connected to a supply voltage (18); and
> > > the collector (32) of the input transistor (22) is connected to the base (39) of the output transistor (24).

2. Sensor system (10) according to claim 1 wherein the gate supply (12) comprises an electrical source providing power to the input (28) of the apparatus (16) when enabled.

3. Sensor system (10) according to any one of the preceding claims wherein the circuitry (17) further comprises a first series resistor (50) connected between the base (34) and the emitter (30) of the input transistor (22), such that the output (26) of the apparatus (16) is connected to the electrical ground when the gate supply (12) is disabled.

4. Sensor system (10) according to any one of the preceding claims wherein the circuitry (17) further comprises a sensing element (40) connected immediately in series with the collector (38) of the output transistor (24), said sensing element (40) detecting a load modulation on the output (26) of the apparatus (16) occurring when said sensor (14) detects the user (46).

5. Sensor system (10) according to claim 4 wherein the sensor system (10) further comprises a supervisor (42) for supervising the sensing element (40).

**6.** Sensor system (10) according to any one of claims 4 to 5 wherein the sensing element (40) is a sense resistor (40) connected immediately in series with the collector (38) of the output transistor (24), the load modulation inducing a voltage variation over the sense resistor (40).

**7.** Sensor system (10) according to any one of the preceding claims wherein the circuitry (17) further comprises a second series resistor (48) connected immediately in series with the emitter (30) of the input transistor (22), the second series resistor (48) being adapted to withstand with short circuit to ground on the output (26).

**8.** Sensor system (10) according to any one of the preceding claims wherein the circuitry (17) further comprises a third series resistor (52) connected between the input (28) of the apparatus (16) and the gate supply (12).

**9.** Sensor system (10) according to any one of claims 3, 6, 7 and 8 taken in combination with claim 4, wherein any one of the resistors (40, 48, 50, 52) is the sensing element (40).

**10.** Sensor system (10) according to any one of the preceding claims wherein the gate supply (12) is a CMOS gate.

**11.** Sensor system (10) according to any one of the preceding claims wherein the circuitry (17) further comprises a diode (45) having an anode and a cathode,

said anode being connected to the emitter (30) of the input transistor (22), and
said cathode being connected to the base (34) of the input transistor (22).

**12.** Sensor system (10) according to any one of the preceding claims wherein the sensor (14) is a proximity sensor.

**13.** Vehicle (8) comprising the sensor system (10) according to any one of the preceding claims.

**14.** Vehicle (8) according to claim 13 wherein the vehicle (8) comprises a door handle and the door handle comprises the sensor (14).

**Patentansprüche**

**1.** Sensorsystem (10) für Fahrzeuge, das konfiguriert ist zum Verbinden einer Gate-Versorgung (12) mit einem Sensor (14), wobei das System (10) aufweist:

den Sensor (14), der einen Benutzer (46) erfasst;
die Gate-Versorgung (12), die Leistung an eine Vorrichtung (16) zuführt;
wobei die Vorrichtung (16) aufweist:

einen Eingang (28), der mit der Gate-Versorgung (12) verbunden ist, zum Empfangen von Leistung von der Gate-Versorgung (12);
eine Schaltung (17), die einen Pegel der von der Gate-Versorgung (12) empfangenen Leistung verstärkt; und
einen Ausgang (26), der mit dem Sensor (14) verbunden ist, zum Vorsehen des verstärkten Leistungspegels an den Sensor (14);

wobei die Schaltung (17) aufweist:

einen Schalter (44) zum Aktivieren/Deaktivieren der Gate-Versorgung (12);
einen NPN-Bipolartransistor (22) mit einer Basis (34), einem Kollektor (32) und einem Emitter (30);
einen PNP-Bipolartransistor (24) mit einer anderen Basis (39), einem anderen Kollektor (38) und einem anderen Emitter (36);
wobei der NPN-Bipolartransistor (22) ein Eingangstransistor (22) ist;
der PNP-Bipolartransistor (24) der Ausgangstransistor (24) ist;
die Basis (34) des Eingangstransistors (22) mit dem Eingang (28) der Vorrichtung (16) verbunden ist;
der Kollektor (38) des Ausgangstransistors (24) und der Emitter (30) des Eingangstransistors (22) miteinander mit dem Ausgang (26) der Vorrichtung (16) verbunden sind;
der Emitter (36) des Ausgangstransistors (24) mit einer Versorgungsspannung (18) verbunden ist; und
der Kollektor (32) des Eingangstransistors (22) mit der Basis (39) des Ausgangstransistors (24) verbunden ist.

2. Sensorsystem (10) gemäß Anspruch 1, wobei die Gate-Versorgung (12) eine elektrische Quelle aufweist, die Leistung an den Eingang (28) der Vorrichtung (16) vorsieht, wenn sie aktiviert ist.

3. Sensorsystem (10) gemäß einem der vorhergehenden Ansprüche, wobei die Schaltung (17) weiter einen ersten Serienwiderstand (50) aufweist, der zwischen der Basis (34) und dem Emitter (30) des Eingangstransistors (22) verbunden ist, so dass der Ausgang (26) der Vorrichtung (16) mit elektrischer Masse verbunden ist, wenn die Gate-Versorgung (12) deaktiviert ist.

4. Sensorsystem (10) gemäß einem der vorhergehenden Ansprüche, wobei die Schaltung (17) weiter ein Erfassungselement (40) aufweist, das unmittelbar in Serie mit dem Kollektor (38) des Ausgangstransistors (24) verbunden ist, wobei das Erfassungselement (40) ein Auftreten einer Lastmodulation an dem Ausgang (26) der Vorrichtung (16) erfasst, wenn der Sensor (14) den Benutzer (46) erfasst.

5. Sensorsystem (10) gemäß Anspruch 4, wobei das Sensorsystem (10) weiter eine Überwachungseinrichtung (42) zum Überwachen des Erfassungselements (40) aufweist.

6. Sensorsystem (10) gemäß einem der Ansprüche 4 bis 5, wobei das Erfassungselement (40) ein Erfassungswiderstand (40) ist, der unmittelbar in Serie mit dem Kollektor (38) des Ausgangstransistors (24) verbunden ist, wobei die Lastmodulation eine Spannungsvariation über den Erfassungswiderstand (40) induziert.

7. Sensorsystem (10) gemäß einem der vorhergehenden Ansprüche, wobei die Schaltung (17) weiter einen zweiten Serienwiderstand (48) aufweist, der unmittelbar in Serie mit dem Emitter (30) des Eingangstransistors (22) verbunden ist, wobei der zweite Serienwiderstand (48) ausgebildet ist, um einem Kurzschluss mit Masse an dem Ausgang (26) standzuhalten.

8. Sensorsystem (10) gemäß einem der vorhergehenden Ansprüche, wobei die Schaltung (17) weiter einen dritten Serienwiderstand (52) aufweist, der zwischen dem Eingang (28) der Vorrichtung (16) und der Gate-Versorgung (12) verbunden ist.

9. Sensorsystem (10) gemäß einem der Ansprüche 3, 6, 7 und 8 in Kombination mit Anspruch 4, wobei einer der Widerstände (40, 48, 50, 52) das Sensorelement (40) ist.

10. Sensorsystem (10) gemäß einem der vorhergehenden Ansprüche, wobei die Gate-Versorgung (12) ein CMOS-Gate ist.

11. Sensorsystem (10) gemäß einem der vorhergehenden Ansprüche, wobei die Schaltung (17) weiter eine Diode (45) mit einer Anode und einer Kathode aufweist,
wobei die Anode mit dem Emitter (30) des Eingangstransistors (22) verbunden ist, und
die Kathode mit der Basis (34) des Eingangstransistors (22) verbunden ist.

12. Sensorsystem (10) gemäß einem der vorhergehenden Ansprüche, wobei der Sensor (14) ein Nähesensor ist.

13. Fahrzeug (8) mit dem Sensorsystem (10) gemäß einem der vorhergehenden Ansprüche.

14. Fahrzeug (8) gemäß Anspruch 13, wobei das Fahrzeug (8) einen Türgriff aufweist und der Türgriff den Sensor (14) aufweist.

**Revendications**

1. Système détecteur (10) pour véhicules, configuré pour interfacer une alimentation de grille (12) avec un détecteur (14), le système (10) comprenant :

   le détecteur (14) détectant un utilisateur (46) ;
   l'alimentation de grille (12) fournissant de l'énergie à un appareil (16) ;
   l'appareil (16) comprenant :

une entrée (28) connectée à l'alimentation de grille (12) pour recevoir de l'énergie de l'alimentation de grille (12) ;

un circuit (17) amplifiant le niveau de la puissance reçue de l'alimentation de grille (12) ; et

une sortie (26) connectée au détecteur (14) pour fournir le niveau de puissance amplifié au détecteur (14) ;

dans lequel le circuit (17) comprend :

un commutateur (44) pour activer/désactiver l'alimentation de grille (12) ;

un transistor bipolaire NPN (22) ayant une base (34), un collecteur (32) et un émetteur (30) ;

un transistor bipolaire PNP (24) ayant une autre base (39), un autre collecteur (38) et un autre émetteur (36) ;

le transistor bipolaire NPN (22) est un transistor d'entrée (22) ;

le transistor bipolaire PNP (24) est le transistor de sortie (24) ;

la base (34) du transistor d'entrée (22) est connectée à l'entrée (28) de l'appareil (16) ;

le collecteur (38) du transistor de sortie (24) et l'émetteur (30) du transistor d'entrée (22) sont connectés ensemble à la sortie (26) de l'appareil (16) ;

l'émetteur (36) du transistor de sortie (24) est connecté à une tension d'alimentation (18) ; et

le collecteur (32) du transistor d'entrée (22) est connecté à la base (39) du transistor de sortie (24).

2. Système détecteur (10) selon la revendication 1, dans lequel l'alimentation de grille (12) comprend une source électrique fournissant de l'énergie à l'entrée (28) de l'appareil (16) lorsqu'elle est activée.

3. Système détecteur (10) selon l'une quelconque des revendications précédentes, dans lequel le circuit (17) comprend en outre une première résistance série (50) connectée entre la base (34) et l'émetteur (30) du transistor d'entrée (22), de sorte que la sortie (26) de l'appareil (16) est connecté à la masse électrique lorsque l'alimentation de grille (12) est désactivée.

4. Système détecteur (10) selon l'une quelconque des revendications précédentes, dans lequel le circuit (17) comprend en outre un élément de détection (40) connecté immédiatement en série avec le collecteur (38) du transistor de sortie (24), ledit élément de détection (40) détectant une modulation de charge sur la sortie (26) de l'appareil (16) se produisant lorsque ledit détecteur (14) détecte l'utilisateur (46).

5. Système détecteur (10) selon la revendication 4, lequel système détecteur (10) comprend en outre un superviseur (42) pour superviser l'élément de détection (40).

6. Système détecteur (10) selon l'une quelconque des revendications 4 à 5, dans lequel l'élément de détection (40) est une résistance de détection (40) connectée immédiatement en série avec le collecteur (38) du transistor de sortie (24) la modulation de charge entraînant une variation de tension sur la résistance de détection (40).

7. Système détecteur (10) selon l'une quelconque des revendications précédentes, dans lequel le circuit (17) comprend en outre une deuxième résistance série (48) connectée immédiatement en série avec l'émetteur (30) du transistor d'entrée (22), la deuxième résistance série (48) étant adaptée à résister à un court-circuit à la masse sur la sortie (26).

8. Système détecteur (10) selon l'une quelconque des revendications précédentes, dans lequel le circuit (17) comprend en outre une troisième résistance série (52) connectée entre l'entrée (28) de l'appareil (16) et l'alimentation de grille (12).

9. Système détecteur (10) selon l'une quelconque des revendications 3, 6, 7 et 8 prises en combinaison avec la revendication 4, dans lequel l'une quelconque des résistances (40, 48, 50, 52) est l'élément de détection (40).

10. Système détecteur (10) selon l'une quelconque des revendications précédentes, dans lequel l'alimentation de grille (12) est une grille CMOS.

11. Système détecteur (10) selon l'une quelconque des revendications précédentes, dans lequel le circuit (17) comprend en outre une diode (45) ayant une anode et une cathode,
ladite anode étant connectée à l'émetteur (30) du transistor d'entrée (22), et
ladite cathode étant connectée à la base (34) du transistor d'entrée (22).

12. Système détecteur (10) selon l'une quelconque des revendications précédentes, dans lequel le détecteur (14) est un détecteur de proximité.

13. Véhicule (8) comprenant le système détecteur (10) selon l'une quelconque des revendications précédentes.

14. Véhicule (8) selon la revendication 13, dans lequel le véhicule (8) comprend une poignée de portière et la poignée de portière comprend le détecteur (14).

**Fig. 1**

**Fig. 2**

**Fig. 3**

**Fig. 4**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013249570 A